# EUROPEAN PATENT APPLICATION

(11) **EP 2 711 738 A1**
(43) Date of publication of application: **26.03.2014**
(21) Application number: 12006650.1
(22) Date of filing: 21.09.2012
(51) Int. Cl.: G01T 1/16, G01R 33/48, G06T 11/00

(54) **A method and a device to generate virtual X-ray computed tomographic image data**

(71) Applicant: Technische Universität München, 80333 München (DE)
(72) Inventor: Shi, Kuangyu, DE - 81735 München (DE); Cheng, Xiaoyin, DE - 80805 München (DE); Ziegler, Sibylle, DE - 80797 München (DE)
(74) Representative: FDST Patentanwälte

(57) **Abstract**

A method and a device were disclosed to generate virtual computed tomographic (VCT) image data, where radionuclide or X-ray based transmission scan (TX) data of an object are transformed into the virtual computed tomographic (VCT) image data with the aid of magnetic resonance imaging (MRI) data of the same object.

## Description

The present invention relates to a method and to a device to generate virtual computed tomographic (VCT) image data based on transmission scan (TX) data. Especially, the invention could be used in clinical and preclinical applications for diagnostic and therapeutic purposes. In particular, the invention including its hardware and software can be realized in a machine of transmission sources (gamma-ray or X-ray) and radiation detectors or cameras integrated in or connected with magnetic resonance imaging (MRI).

Computed tomography (CT) is one important medical imaging modality for the diagnosis and therapy planning. It captures object attenuation under X-ray radiation, which is sensitive to the difference in physical density or chemical composition (atomic number) of the consisting materials. Thus it allows discrimination of tissues such as air, muscle, fat and bone, which have contrast according to their difference in X-ray attenuation.

With the advantages in locating and examining tissues and objects such as bone, lung and metal implants, CT is necessary or even mandatory in many applications. For example, it serves as basis for modern radiotherapy treatment planning (RTP), which not only allows an accurate geometrical outline of tissues such as bone and air cavities but also provides the data related to X-ray absorption for radiation dose calculation.

Magnetic resonance imaging (MRI) is an imaging modality which uses magnetic field and radio waves to image nuclei of hydrogen atoms inside the object or body. It produces a map of variations in the relaxation times of hydrogen nuclei in the water molecules embedded in the object. These relaxation times depend for example on the types of tissues and even their healthy status. It can generate good contrast and reveal subtleties among soft tissues even of similar radiation attenuation properties, which are not distinguishable in CT. Thus only CT is not enough for accurate diagnosis or therapy in many situations and MRI has advantages to provide important complementary information. For example, In RTP of brain tumor, MRI is often necessary for precise tumor delineation.

In the past, if images of both CT and MRI are required for a patient, it can be obtained by scanning using each modality separately. The patients need to switch between the Imaging devices and it is usually hard to obtain a simultaneous or nearly-simultaneous scanning. These solutions increase burden for patients as well as labor efforts of staffs. The economic costs are difficult to reduce with these solutions. In particular, the radiation dose, which the patients receive during the acquisitions of a regular CT, is relatively high between 1.5 - 21 mSv. This can be increased further for the patients, who need to do imaging of both modalities more than one time. For example, during the therapy procedure, treatment planning needs to be adapted to morphological changes. And the applications of conventional separate scanning for these situations are extremely limited.

From Stanescu, T., Jans, H.S., Pervez, N., Stavrev, P., Fallone, B.G.: "A study on the magnetic resonance imaging (MRI)-based radiation treatment planning of intracranial lesions", Phys. Med. Biol. 53 (2008), 1516-1521 and Jonsson, J., Karlsson, M., Karlsson, M., Nyholm, T.: "Treatment planning using MRI data: an analysis of the dose calculation accuracy for different treatment regions", Radiat. Oncol. 5 (2010) 62-69 it is known to generate virtual CT (VCT) based on MRI images to avoid multiple scanning as well as additional radiation doses of CT. However, MRI works according to a totally different physical principle compared to CT. Thus it is not possible to directly link the MRI signal to a CT signal. VCT images for example can only be synthesized after classifications of tissues on MRI data. However, structures such as bone or air are insensitive to MRI and thus It is difficult to extract these structures with only MRI. Many bone or cavity structures therefore are missing in synthesized VCT from MRI. Furthermore, the individuality of radiation attenuation-related intensity within a tissue, such as the difference In bone density, is missing in the VCT based on only MRI.

Another problem are the geometrical distortions of MRI images, especially the patient specific distortions as disclosed in Jonsson, J., Karlsson, M., Karlsson, M., Nyholm, T.: "Treatment planning using MRI data: an analysis of the dose calculation accuracy for different treatment regions", Radlat. Oncol. 6 (2010) 62-69, which may reduce the accuracy of synthesized VCT images. Also similar to other MRI based methods, the individuality of intensity values in synthesized VCT is missing.

Besides CT, from US 8,073,525 B2 it is also known to combine the method of MRI with the method of positron emission tomography (PET) in one single machine. PET is also a method for producing tomography and it is usually used to display the distribution of a radioactively marked substance, e. g. a radiopharmaceutical, In a living organism. The substance is introduced into the organism and accumulates in specific body tissues in accordance with its biochemical functions. The coincidence of positron emission of the radionuclide is detected and then reconstructed to form tomography images for imaging underlying biochemical reactions. As the biochemical reactions differentiate in specific physiological functions, PET does not directly supply anatomical information. A combined PET/MRI-machine using both MRI and PET will therefore allow both physiological and anatomical imaging of the studied object for diagnostic and treatment purposes.

For the reconstruction of proper PET images, it is mandatory to have the attenuation data of the imaged substance under the irradiation of the radionuclide, The procedure of compensating the influence of the object attenuation is called attenuation correction (AC). Thus, for the purpose of attenuation correction (AC), the transmission data (TX) of the imaged object is usually obtained in conjunction with the emission data.

From US 2007/221850 A1, Zaldl H., Hasegawa B.: "Determination of the Attenuation Map in Emission Tomography", J. Nucl. Med. 44 (2003) 291-315 and Kinahan P. E., Hasegawa B. H., Beyer T.: "X-ray-paced attenuation correction of positron emission tomography/computed tomography scanners in seminars in nuclear medicine", Vol. 33, No. 3 (July), 2003, 166-179 it is further known to use a transmission scan (TX) for the attenuation correction of positron emission tomography (PET) and single photon emission computed tomography (SPECT), which compensates the influence of inhomogeneous gamma-ray attenuation inside the studied object or body.

A transmission scan (TX) acquires the radiation attenuation data via an external source of annihilative radioactive source (e.g. ⁶⁸Ge/Ga for PET TX) or single photon emitters (e.g. ¹¹⁷Cs for PET TX, e.g. ¹³³Ba, ¹⁶³Gd for SPECT TX) or a rotating X-ray tube. A transmission scan takes usually 2-10 min conducted simultaneously or prior/after to an emission scan for PET and 15-30 min conducted simultaneously to an emission scan for SPECT. The dose of a transmission scan is generally insignificant compared to a computed tomography (CT). Images reconstructed from the acquired transmission scan data show the attenuation of the used radiation source by the studied object. The measured attenuation depends on the attenuation coefficients of the object related to the used radiation source, which varies with the energy of the incident beam and with the density as well as with the atomic number of the absorption object. In particular, TX measures the attenuation coefficients of tissues for gamma-ray or low-dose X-ray while CT records the attenuation coefficients of tissues for an X-ray spectrum. TX data may be used for attenuation correction of PET and SPECT. However, due to the low acquisition statistics, TX Images In general are very noisy and have a low resolution, which does not meet the requirements of diagnosis and treatment.

For the combined PET/MRI-machine, there is no transmission data available directly. MRI data is usually applied to generate the virtual transmission data for the attenuation correction (AC). It has the same problem as MRI based VCT for radiotherapy treatment planning, where it is not possible to directly link the MRI signal to a CT signal and there is distortions with the MRI data. However, it is still applicable for the purpose or attenuation correction, which requires low precision of the transmission data.

Hofmann, M., Steinke, F., Scheel, V., et al.: MRI-based attenuation correction for PET/MRI: "A novel approach combining pattern recognition and atlas registration", J. Nucl. Med. 49 (2008) 1875-1883 disclose an atlas based method where virtual transmission data are synthesized by registering an anatomical atlas to MRI images. Through aligning the morphological structures, it is possible to interpolate the missing bone and cavity structures in MRI. However, the elastic registration procedure depends on many factors and is insensitive to anatomical variations, in particular abnormalities.

The current calculation of VCT based on only MRI does not meet the general requirements of accuracy for diagnosis and therapy purposes and therefore cannot substitute a conventional CT in a wide range of applications.

It is therefore an object of the present invention to provide for a method and for a device to generate virtual computed tomographic (VCT) Image data for diagnostic and therapeutic purposes, allowing in particular avoiding an additional CT in case of MRI.

The first object with regard to the method is achieved with regard to the invention by a method to generate virtual computed tomographic (VCT) image data, where radio nuclide or X-ray based transmission scan (TX) data of an object are transformed into the virtual computed tomographic (VCT) image data with the aid of magnetic resonance imaging (MRI) data of the same object.

In a first step, the invention realizes that both, TX and CT reflect the properties of different areas/tissues of the studied object relating to the photoelectric and the Compton effects and that it is possible to link the values of TX to values of CT directly. This has been published by Burger, C., Goerres, G., Schoenes, S., Buck, A., Lonn, A., von Schulthess, G.: "PET attenuation coefficients from CT images: experimental evaluation of the transformation of CT into PET 511-keV attenuation coefficients", Eur. J. Nucl. Med. Mol. Imaging 29 (2002) 922-927.

In a second step, the invention realizes that CT and MRI of an identical object or patient or animal visualize the same anatomy in different perspective. Their images generally look similar except In specific details. There is a large amount of redundancy in the anatomical structures between the images of two modalities.

The present invention utilizes the inherent anatomical consistency to reduce the redundancy in the measurements and develops TX for diagnostic and therapeutic purposes. The invention develops a method to utilize the inherent anatomical consistency between TX and MRI for the improvement of the image quality of TX. It enables the generation of CT-related image data based on TX and MRI data. It provides a substitution of real CT and reduces the redundancy during the measurements. In particular, it reduces the exposed radiation dose and enables simultaneous or nearly simultaneous acquisitions in hybrid imaging modalities equipped with radiation detectors integrated In or connected to MRI. These radiation detectors can be dedicated for TX imaging or originated for emission imaging such as PET, SPECT with an extension function for TX.

The present invention includes a method of TX imaging and a method of MRI imaging. These two imaging methods are carried out simultaneously or sequentially without changing the object position. They can be done also in accompany to an emission scan such as PET or SPECT.

The present invention includes a series of algorithms to achieve substitutional functionalities, avoiding additional CT based on the acquired transmission data and MRI data. These algorithms include the reconstruction of transmission data and MRI data, the TX-CT mapping of attenuation coefficients to CT Hounsfield Units (HU), the correction of MRI distortions, the analyzing of MRI images to extract features and structures, the enhancement of the mapped CT images based on the analyzed MRI images, the classification of tissues based on enhanced mapped CT, MRI and atlas data and the processing and correction based on the classified tissues to obtain the final virtual CT images.

According to one preferred embodiment of the invention the transmission scan data of the object, body or patient are acquired at a lower dose as compared to a regular X-ray computed tomography (CT) of the same object, body or patient, In particular at a dose between 0.1 % and 4.0 % when compared to the dose of the computed tomography (CT). Such low doses are insignificant for the patient but are useful to generate TX image data for the transformation into VCT image data by using MRI. As the radiation dose of a regular CT is relatively high between 1.5 and 21 mSv, the preferred radiation dose of the transmission scan will be below 0.5 mSv. According to Almeida, P., Bendriem, B., de Dreuille, O., Peltier, A., Perrot, C., Brulon, V.: "Dosimetry of transmission measurements in nuclear medicine: a study using anthropomorphic phantoms and thermoluminescent dosimeters", Eur. J. Nucl. Med. 25 (1998) 1435-1441 radiation doses for a transmission scan are for example 1.6 % (brain) and 2.4 % (cardiac) compared to CT for PET TX, and 0.3 % (brain) and 0.2 % (cardiac) compared to CT for SPECT TX.

The TX acquisition In the present invention generally follows conventional TX measurements. In a preferred embodiment the transmission sources can be emitters of annihilative activities, In particular ⁶⁸Ge/Ga and/or single γ-emitters, in particular ¹³⁷Cs, ¹³³Ba or ¹⁵³Gd, and/or X-ray sources, In particular an X-ray tube. The used external sources can be of ring, rotating rods or points, fan-beam or cone beam geometries with collimations. The transmission measurement can be operated in coincidence mode or in single photon mode. Both transmission and blank scans are acquired accordingly.

Also the MRI data acquisition in the present invention generally follows routine MRI measurements using a set of different radio frequency and gradient pulses. Images such as T₁ weighted, T₂ weighted, T*₂ weighted, contrast enhanced, fat suppression, DIXON four point, functional and/or ultrashort pulse sequence, can be acquired. Proper selections of types of MRI images will favorably enhance the performance of the present invention and will improve the accuracy of VCT. Mutual information can be used as criteria to choose proper MRI Images as input.

The reconstruction algorithm for MRI data in the present invention also is based on routine MRI reconstruction algorithms, which are well known. It considers in particular the influence of the transmission source when the data is acquired simultaneously to the transmission scan. The influence will be calibrated on phantoms and then be compensated during the reconstruction procedure. According to yet another embodiment of the invention the measured transmission scan data are reconstructed to transmission image data with an analytical algorithm, in particular with a filtered backprojection algorithm, and/or with an iterative algorithm, In particular with a maximum likelihood expectation-maximization algorithm.

The used algorithms for the reconstructions of the transmission scan data in principle are already known. In particular, the reconstruction is achieved without smoothing the sinogram, which is the histogram, calculated from the projection data. This smoothing in the past was used to reduce the noise due to low measurement statistics of TX, which leads to a sacrifice of the image resolution. Besides the used reconstructions algorithms a series of corrections such as scattering correction, arc correction, dead-time correction and/or cross-talk correction maybe included in the reconstruction algorithm of the acquired transmission data.

Additional regularization such as sparse regularization can be imposed on the iteratlve reconstruction algorithms in the present invention to reduce the noise. The sparsity is formulated for example on a discrete gradient or wavelet transform. Regularization terms are expressed in L1-norm or total variation (TV) norm in the objective function, which can be solved using algorithms such as conjugated gradient, partial differential equation, Lq-quasinorm, operator-splitting, variable-splitting etc. as disclosed in Huang, J., Zhang, S., Metaxas D. N.: "Efficient MR image reconstruction for compressed MR imaging", Medical image Analysis 15 (2011) 670-679. Preferably, an image enhancement algorithm is combined with the iterative algorithm.

In yet another preferred embodiment of the invention the transmission scan data are transformed into Hounsfield-Units (HU). In particular an image of the attenuation coefficients of the object is calculated from the transmission scan data via image reconstruction, and the calculated attenuation coefficients are transformed into the Hounsfield-Units (HU) by calibrating the relations between the attenuation coefficients of the radiation used for the transmission scan and the X-ray attenuation coefficients.

The so called TX-CT mapping algorithm in the present invention transforms the reconstructed image of gamma-ray attenuation coefficients to HU values. This is achieved by calibrating the relations between the X-ray attenuation coefficients and the attenuation coefficients for the gamma-ray emitted by the transmission source either theoretically or experimentally using tissue phantoms consisting of different materials. The TX-CT mapping algorithm especially is based on a relation between the attenuation coefficients of TX and CT as it is published in Burger, C., Goerres, G., Schoenes, S., Buck, A., Lonn, A., von Schulthess, G.: "PET attenuation coefficients from CT images: experimental evaluation of the transformation of CT into PET 511-keV attenuation coefficients", Eur. J. Nucl. Med. Mol. Imaging 29 (2002) 922-927. In a favorable embodiment the relation Is expressed using piece-wise polynomials and a least-square algorithm is used to achieve a best fitting of the experimental data.

In yet another preferred embodiment of the invention the transmission scan data are used to correct distortions in the magnetic resonance imaging data.

Distortions in MRI images are caused by scanner related factors such as the Inhomogeneous magnetic field, nonlinear gradient field and patient-specific factors such as susceptibility and chemical shift local variations (see for example Stanescu, T., Jans, H.S., Pervez, N., Stavrev, P., Fallone, B.G.: "A study on the magnetic resonance imaging (MRI)-based radiation treatment planning of intracranial lesions", Phys. Med. Biol. 53 (2008) 1516-1521. These factors do not affect the TX images as well as the mapped VCT images. It Is therefore possible to register the distorted MRI images to the mapped VCT images to correct the distortions. This can be solved either by intensity based registration algorithms or feature based algorithms. Regularization may be added to the objective function to reduce the influence of the noise on the displacement field.

In particular, the MRI distortion correction algorithm preferably is based on a non-rigid (elastic, deformable) registration according to Modersitzki J.: "Numerical methods for image registration", Oxford University Press, 2004. The non-rigid registration restricts the freedom of the deformation concerning that the distortion of MRI is within a certain range, which is dependent on the scanning machine and the imaging object. The machine and patient specific regularization on the deformation freedom improves the stability of the non-rigid registration and thus improve the accuracy of distortion correction.

When the transmission scan data and the magnetic resonance imaging data are acquired simultaneously, it is preferred to compensate the influence of the transmission scan method to the magnetic resonance imaging method during reconstruction of the magnetic resonance imaging data.

The MRI imaging algorithm in a preferred embodiment of the invention deals with a set of images acquired in MRI imaging using a set of different radio frequency and gradient pulses. The pulse sequences such as the repetition time (TR), the echo time (TE), the inversion time (TI), characterize the type of MRI images and highlight different aspects. The analyzing algorithm according to a preferred embodiment of the present invention may reduce the dimension of a series of various types of MRI images (e.g. T₁ weighted, T₂ weighted, T*₂ weighted, contrast enhanced, DIXON four point, fat suppression, functional, ultrashort pulse sequence), filters the noise and extracts the features accordingly. Multivariate feature extraction algorithms such as principal component analysis, factor analysis or Independent component analysis in a preferred embodiment may be applied here.

According to yet another preferred embodiment of the invention the magnetic resonance imaging data are used to enhance the transmission scan data, in particular to enhance the transformed Hounsfield-Units (HU) Image data from the transmission scan data. This so-called joint enhancement algorithm is used to filter out noise such as artifact spots in the mapped CT images while preserving the main anatomical structures. MRI images or MRI feature images are applied to regularize the enhancement procedure. In particular, the object or anatomical structures in the magnetic resonance imaging data are integrated into an image processing filter for the enhancement of the transmission scan image data, in particular to enhance the transformed Hounsfield-Units (HU) image data from the transmission scan (TX) data.

One option is to use a so-called joint-anisotropic diffusion method (JAD), which is an extension of the anisotropic diffusion method as disclosed in Weickert J.: "Anisotropic Diffusion In Image Processing", Teubner-Verlag, Stuttgart, 1998. JAD reshapes the diffusion tensor by combining the internal (TX, mapped CT or VCT) and external (MRI, MRI feature images) structural information. JAD locally guides the mass flux to the direction which favors the common structure between internal and external. Globally, JAD leads to an increase of the similarity between the internal and external images, which can be described using mutual information, The JAD is solved iteratively with mutual information to control the number of iterations. The external image is selected among MRI images and MRI feature images to find optimal structural images which have maximum starting mutual information with the internal images.

Preferably, the object or anatomic structures can be extracted from the magnetic resonance image (MRI) data by using a specific algorithm like a principle component analysis, a factor analysis or an independent component analysis. In an alternative, the raw MRI images can be used directly with its original contours.

In yet another favorable embodiment of the invention the VCT image can be further enhanced by multivariate classification of object structures. Areas of the studied object having different X-ray attenuation coefficients, in particular different tissues, in the transmission scan image data are classified by the use of a multivariate input, in particular by the use of transmission scan data, magnetic resonance imaging data, and/or atlas data.

This tissue classification algorithm distinguishes different object areas or anatomical structures based on multivariate input such as TX, VCT, MRI image series and/or MRI feature images. The use of atlas data is not necessary but can be also incorporated to assist the classification. The classification is achieved using routine algorithms such as clustering, support vector machine (SVM), expectation-maximization (EM), neural networks etc. as disclosed for example in Bishop C. M.: "Pattern Recognition and Machine Learning", Springer 2006. The classification method is preferably used in the transmission scan image data to enhance further the contrast.

Any postprocessing and correction algorithms may be used In the present invention to enhance the VCT images further and to correct the possible bias based on the knowledge of the classified tissues or object areas. For example, the values of the distinguished fat structures in VCT are adapted and corrected to improve the contrast to the surrounding neighbors.

The aforementioned method to generate virtual CT image data including hardware and software can be realized in a machine of transmission sources (gamma-ray or X-ray) and radiation detectors and/or cameras integrated in or connected with MRI. The radiation detectors and/or cameras can be dedicated for TX imaging or originated for emission imaging such as PET, SPECT with an extension function for TX.

TX in the present invention can be integrated into a MRI-machine or into a system of emission scan and MRI.

The second object with regard to the device is achieved with regard to the invention by providing a device to be implemented in a combined PET/MRI-machine or in a combined SPECT/MRI-machine, comprising an external transmission scan (TX) source, in particular an annihilative radioactive source or single-photon emitting radionuclide or an X-ray tube, and a software module capable to carry out the aforementioned method.

In a preferred embodiment the external transmission scan source is a ring-shaped radionuclide, The transmission sources or radiation detectors and their accompanied operating hardware preferably are produced with MRI compatible materials or with magnetic shielding for the integration or connection to MRI. These possibilities give a large flexibility of realization of the present invention.

The invention therefore provides for a combined TX/PET/MRI- or TXISPECT/MRI-machine comprising at least one detector element for acquiring PET- or SPECT-data respectively and the aforementioned device, where said at least one element of radiation detectors is used for the acquisition of the transmission scan data. By using or Implementing the invention into a PET/MRI- or SPECT/MRI-machine an additional CT modality could be avoided.

These and various other features of the present invention will become better understood upon reading of the following description of the preferred embodiments in conjunction with the accompanying drawings.
- Fig. 1: is a sketch of one embodiment of the invention to generate virtual computed tomographic image data based on transmission scan data and magnetic resonance imaging data,
- Fig. 2: shows the comparison of a real CT and the invention-involved TX, MRI and VCT images of a human brain and two additional plots, explaining the iteration process and comparing a VCT with a CT image, and
- Fig. 3: shows series of images of the human brain according to figure 2, where misclassifications between air and bone are mapped.

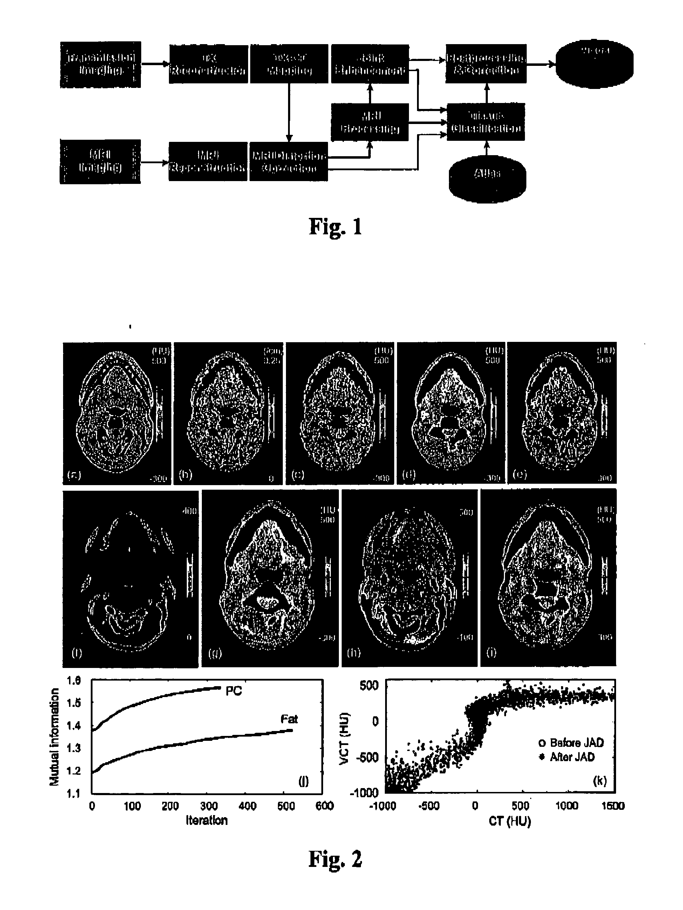

Fig. 1 gives an example of the processing of the measured transmission scan (TX) and magnetic resonance imaging (MRI) data. As already described before the TX-and the MRI data acquisition in the present invention generally follows conventional and/or routine TX- and MRI measurements. Also the used methods for the reconstruction of TX- and MRI-images based on the measured TX- and MRI-data in the present invention are based on routine reconstruction algorithms. The TX-CT mapped Image of the transmission scan data is also used for a correction of the distortions in the MRI image. The processed MRI image data - as described before - are used in the joint enhancement process to improve the quality of the TX-CT mapped image data, especially to reduce the noise therein. After implementation of postprocessing and correction algorithms and a tissue classification method based on TX, MRI and Atlas data, from the acquired transmission scan data the virtual CT data are generated.

The invention is not limited to the method as shown in Fig.1. For example, the MRI distortion correction can be done directly after the TX reconstruction. The MRI processing can be done before the distortion correction. The joint enhancement can be done after the tissue classification etc. Also some steps are not mandatory to be carried out and can be skipped without influencing the functionality of the present invention. For example the tissue classification and postprocessing steps can be skipped if the application is insensitive to more detail structures. Otherwise, the MRI distortion correction can be skipped in the applications where the distortion is negligible.

For the proof of concept, an example virtual machine was implemented with the integration of a ⁶⁸Ga ring source in a machine of ring detectors integrated in a MRI-machine, The virtual machine was implemented in the software module "GATE", which is a dedicated simulation system for emission scanning like PET or SPECT, CT or radiotherapy based on realistic modeling of radiologic interaction and detection method (Santin, G., Strul, D., Lazaro, D., et al.: "GATE: a Geant4-based simulation platform for PET and SPECT integrating movement and time management", IEEE Trans. Nucl. Sci. 50 (2003) 1518-1521. As an example, the present invention was realized as a module of a 100 MBq ⁶⁸Ga ring source (1 mm thick, 15 cm radius) which was placed in the center of the field of view of the machine. Real CT images were classified into bone, muscle, brain, adipose and air and then virtually implemented in the center of the field of view of the virtual system with the transmission module. The TX and blank scan were measured for 6 min.

The acquisitions of TX and blank scans were binned into projection data (i. e. sonograms) with 344 radial bins, 252 projection views without any smoothing and corrected with the blank scan. TX was reconstructed using a conventional maximum likelihood expectation-maximization reconstruction algorithm for 50 iterations. MRI data obtained from a normal MRI scanner were reconstructed using a routine MRI reconstruction algorithm. For the proof of concept, mapping of gamma-ray attenuation coefficients to CT values, principal component analyses (PCA) for MRI processing and joint anisotropic diffusion (JAD) for joint enhancement were implemented.

The present invention was tested on a patient data set with CT and MRI images with DIXON four point sequences (fat, water, in phase, opposed phase) acquired on the same day and the simulated TX on the virtual machine.

One example slice image of CT and the corresponding simulated TX image are shown In Fig. 2 (panels a, b). After mapping the gamma-ray attenuation coefficients to CT HU values, a noisy VCT image is shown in panel c, where the artifact spots destroy the diagnostic quality. Panel d shows a VCT image based on the reconstructed TX with a general sinogram smoothing. Panel e shows the restoration result using conventional anisotropic diffusion. The artifact spots become enhanced during the image enhancement.

JAD was applied with two different input of MRI image. Panel f shows the DIXON fat MRI image which highlights the fat structure. The corresponding VCT using JAD is shown in panel g. The diffusion stops after 521 iterations and the changes of mutual information during the iterations are displayed in panel j. A principal component analysis (PCA) was applied to 4 MRI images of DIXON four point sequences and the strongest principal component (PC) image (panel h) was sent to JAD. The restored VCT image and the corresponding mutual information development are illustrated in panels i and j. Although the intensities of fat and PC images are quite different, their influences on the results of JAD are not significant. JAD is stable even with a poor structural input With more structural information, the PC image has higher mutual information (MI) to start JAD and the result quality is improved. Higher starting mutual information is preferred for JAD to select a good structural image.

The contrasts of the real CT and the restored VCT are different here. The difference is already observable after mapping TX to CT. A scatter plot of the correlation between VCT and CT (Fig. 2, k) shows that the real CT has a wide value range (-1000 to 2000 HU) while VCT has a range of -1000 to 500 HU. This is caused by the simulation of the TX data in the virtual machine which considers only 5 tissue materials offered by GATE. The detailed materials such as high density bones are not possible to model and therefore reveal system bias, which is not a problem for real measurements.

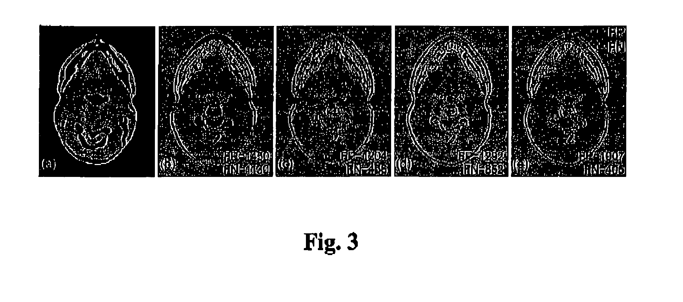

From the VCT using the present invention on the virtual machine, the main bone structures and pharynx (air) are clearly distinguished, which are usually difficult to extract solely with MRI images. The panel a in Fig. 3 shows a result of an MRI based classification by clustering of MRI images of DIXON four point sequences. Each spatial location is associated with a 4 element vector field and Euclidean distance was taken as similarity metrics for a vector based K-Means algorithm. One cluster of the results denotes air and bone. Without additional information, it is not possible to separate bone further from air. The corresponding map of misclassifications without distinction of air and bone is shown in Fig. 3, panel b.

Maps of misclassifications using VCT on the virtual system are displayed in Fig. 3, panels. The number of false positive (FP) and false negative (FN) voxels are displayed on the images accordingly. The TX based VCT has generally low misclassification, even when mixing air and bone. Restored VCT using JAD can reduce both FP and FN compared to original VCT and smooth VCT. The test of overall 5 simulated TX data shows that VCT using JAD can improve the accuracy of 39.8 % - 94.7 % compared to MRI classification, 1.1 % - 27.6 % compared to noisy VCT and 38.3 % - 74.5 % compared to smooth VCT. The differentiation of bone from air is obvious for VCT while not straightforward for MRI and the real improvements compared to MRI without Atlas support can be even larger.

In general, JAD conserves the mass, where the total radiation absorption properties on a large scale do not vary. The difference between the original image and the restored image are constrained locally. This reduces the spread of possible errors for RTP.

Further improvements can be achieved with improved reconstruction algorithm as shown in Fig. 1 with additional regularizations. Also MRI distortion correction and post correction after tissue classification will improve the accuracy.

In the current virtual system, the present invention was configured with a conventional ring source. More advanced TX configurations such as rotating rod source or single photon source can be adapted to improve the statistics and thus the VCT quality. The simultaneous acquisition of TX during emission scan is also possible.

The present invention develops a method to generate virtual CT (VCT) based on transmission imaging (TX) and magnetic resonance imaging (MRI), which utilizes the inherent anatomical consistency to avoid redundant measurements. The present invention provides a substitution of conventional CT and has the following advantages: it reduces the radiation dose significantly; it reduces the economic costs of multimodality imaging; it reduces the complexity and labor efforts of switching between modalities; It improves the efficiency and flexibility of the imaging procedure and enables a wide application of multimodality imaging.

## Claims

1. A method to generate virtual computed tomographic (VCT) image data, where radionuclide or X-ray based transmission scan (TX) data of an object are transformed into the virtual computed tomographic (VCT) image data with the aid of magnetic resonance imaging (MRI) data of the same object.

2. The method according to claim 1, where the transmission scan (TX) data of the object are acquired at a lower dose as compared to a regular X-ray computed tomography (CT) of the same object, in particular at a dose between 0.1 % and 4.0 % when compared to the dose of the computed tomography (CT).

3. The method according to claim 1 or claim 2, where the transmission scan (TX) data are acquired by the use of an annihilative radioactive source, in particular ⁶⁸Ge/Ga, and/or by the use of a single γ-photon emitter source, in particular ¹³⁷Cs, ¹³³Ba or ¹⁵³Gd, and/or by the use of an X-ray source, in particular an X-ray tube.

4. The method according to any of the preceding claims, where the measured transmission scan (TX) data are reconstructed to transmission scan (TX) image data with an analytical algorithm, in particular with a filtered backprojection algorithm, and/or with an iterative algorithm, in particular with a maximum likelihood expectation-maximization algorithm.

5. The method according to any of the preceding claims, where the transmission scan (TX) data are transformed into Hounsfield-Units (HU).

6. The method according to claim 5, where an image of the attenuation coefficients of the reconstructed transmission scan (TX) data is transformed into the Hounsfield-Units (HU) by calibrating the relations between the attenuation coefficients of the radiation used for the transmission scan (TX) and the X-ray attenuation coefficients.

7. The method according to any of the preceding claims, where the transmission scan (TX) data are used to correct distortions in the magnetic resonance imaging (MRI) data.

8. The method according to claim 7, where the distorted magnetic resonance imaging (MRI) data is registered to the image of the attenuation coefficients of the object derived from the transmission scan (TX) data to correct machine and/or object related distortions therein.

9. The method according to any of the preceding claims, where the magnetic resonance imaging (MRI) data are used to enhance the transmission scan (TX) data, in particular to enhance the transformed Hounsfield-Units (HU) image data derived from the transmission scan (TX) data.

10. The method of claim 9, where the object or anatomic structure is represented directly In magnetic resonance imaging (MRI) data or extracted from the magnetic resonance imaging (MRI) data by using a specific algorithm, in particular a principle component analysis, a factor analysis or an independent component analysis.

11. The method according to any of claims 4 to 10, where areas of the object having different X-ray attenuation coefficients, in particular different tissues, in the transmission scan (TX) image data are further classified by the use of a multivariate input, in particular by the use of transmission scan (TX) data, magnetic resonance imaging (MRI) data, and/or atlas data.

12. The method according to claim 11, where the contrast of the transmission scan (TX) image data is enhanced by the use of the classified areas.

13. The method according to any of the preceding claims, where the transmission scan (TX) data and the magnetic resonance imaging (MRI) data are acquired simultaneously or sequentially without changing the object position, and/or where the influence of the transmission scan (TX) method on the magnetic resonance imaging (MRI) method is compensated during reconstruction of the magnetic resonance imaging (MRI) data.

14. A device to be implemented in a combined PET/MRI-machine or in a combined SPECT/MRI-machine, comprising an external transmission scan (TX) source, in particular an annihilative or γ-photon emitting radionuclide or an X-ray tube, and a software module capable to carry out the method as claimed in any of the preceding claims.

15. The device according to claim 14, where the external transmission scan source is a ring-shaped radionuclide or a rotational radioactive rod or a rotating radioactive point source.

16. A combined TX/PET/MRI- or TX/SPECT/MRI-machine comprising at least one element of detectors for acquiring PET- or SPECT-data respectively and a device according to claim 14 or 15, where the detector element is used for the acquisition of the transmission scan (TX) data.
